# EUROPEAN PATENT APPLICATION

(11) **EP 4 797 928 A1**
(43) Date of publication of application: **26.08.2026**
(21) Application number: 25382156.5
(22) Date of filing: 20.02.2025
(51) Int. Cl.: H10P 72/00, C01B 32/186, C01B 32/194, H10P 72/70, C01B 32/198

(54) **SYSTEM FOR TRANSFERRING A THIN FILM AND METHOD THEREOF**

(71) Applicant: INBRAIN Neuroelectronics SL, 08028 Barcelona (ES)
(72) Inventor: Weekamp, Johannes Wilhelmus, 5741 DH Beek en Donk (NL)
(74) Representative: WENDE IP GbR

(57) **Abstract**

The present invention relates to a transfer system (100) for transferring a thin film, e.g. a rGO flakes layer (10), to and on a wafer (12), comprising: a base plate (14), a wafer holder (16) arranged on the base plate (14); a carrier (18) for at least one thin film (10) to be transferred on the wafer (12); a pickup assembly (20) comprising: a pickup arm (22); a pickup head (24), configured to pick up a thin film (10) from the carrier (18) and deposit the thin film (10) on the wafer (12), and a motor, configured to determine movement of the pickup arm (22) between a lifted position and a lowered position, a movement transmission means (26), configured to move the base plate (14) to a desired position; a vacuum generating device, and a controller, the controller being configured to operate the vacuum generating device to generate a vacuum for holding the wafer (12) in place on the wafer holder (16). The invention further relates to a wiping system (300) for wiping a rim area of a thin film (210), e.g. a rGO flakes layer, deposited on a wafer.

## Description

The present invention belongs to the technical field of systems, methods, and techniques for transferring a thin film on a wafer.

As a non-limiting example, said thin film can be a graphene-containing film, in particular a layer of reduced graphene oxide (rGO) flakes.

As a non-limiting example, the wafer can be a 4-inch wafer or a 6-inch wafer.

The wafer may hold one or more thin films, e.g. rGO flakes layers, arranged on one surface.

In particular, the invention provides a transfer system for transferring a thin film, especially a graphene-containing film, e.g. a rGO flakes layer, on a wafer.

The invention further provides a method of transferring a thin film, e.g. a rGO flakes layer, on a wafer, the method being implemented by using the transfer system above.

Still further, the invention provides a wiping system for wiping a rim area of a thin film, deposited on a wafer.

As a non-limiting example, said thin film can be a graphene-containing film, such as a rGO flakes layer.

Eventually, the invention provides a method of wiping a rim area of a thin film, e.g. a rGO flakes layer, deposited on a wafer, the method being implemented by using the wiping system above.

Optionally, the wiping system can be integrated into the transfer system, thereby forming a single, integrated system.

The rim area of a thin film (such as a rGO flakes layer) deposited on a wafer may show an increased thickness, in particular as a consequence of the filtering process for the preparation of the rGO flakes layer. Also, residues, e.g. rGO residues, may be present nearby the rim area.

Accordingly, a wiping operation is required to reduce thickness of the rim area and remove possible residues nearby.

Usually, this is manually carried out by an operator using a wiping device having a handle and a head paddle made of a flexible material, e.g., nylon.

However, the outcome of this manual operation is often sub-optimal.

Accordingly, during the subsequent etching process, at least part of the rim area may still have an increased thickness and/or rGO residues may be present in the surroundings.

Also, manual wiping of the rim area of the thin film is time consuming and burdensome for the operator.

Therefore, there is room for further improvement.

In the light of the above, it is an object of the present invention to provide an improved solution allowing easily transferring a thin film, e.g. a rGO flakes layer, on a wafer with enhanced precision and minimal operator handling, and carrying out wiping of a rim area of the deposited thin film with increased efficiency and accuracy.

According to the invention, a transfer system for transferring a thin film, especially a graphene-containing film, e.g. a reduced graphene oxide (rGO) flakes layer, to and on a wafer, comprises:
a base plate;
a wafer holder configured to hold a wafer, the wafer holder being arranged on the base plate;
a carrier for at least one thin film to be transferred on the wafer;
a pickup assembly comprising:
   a pickup arm;
   a pickup head, configured to pick up a thin film from the carrier and subsequently deposit the thin film on the wafer, and
   a motor, configured to determine movement of the pickup arm between a lifted position and a lowered position,
a movement transmission means, configured to move the base plate to a desired position;
a vacuum generating device, and
a controller,
wherein the controller is configured to:
operate the vacuum generating device to generate a vacuum for holding the wafer in place on the wafer holder.

Moreover, according to the invention, a wiping system for wiping a rim area of a thin film, especially a graphene-containing film, e.g. a reduced graphene oxide (rGO) flakes layer, deposited on a wafer comprises:
a base portion;
a wafer holder, arranged on the base portion, the wafer holder being configured to hold a wafer with at least one thin film deposited on one surface;
a wiping assembly, comprising:
   a wiping device, the wiping device comprising a handle and a head paddle made of a flexible material;
   a wiping device holder, configured for connection to the handle to maintain the wiping device in place for use, and
   a motor for controlling operation of the wiping device, and
a wiping assembly arm, connected to the wiping assembly, the wiping assembly arm being configured to switch between a lifted position and a lowered position.

The present invention provides a transfer system for transferring a thin film on a wafer.

As a non-limiting example, the thin film can be a graphene-containing film.

In particular, the thin film can be a reduced graphene oxide (rGO) flakes layer.

The system comprises a base plate.

The system further comprises a wafer holder, configured to hold a wafer.

The wafer holder is arranged on the base plate.

The system further comprises a carrier for at least one thin film to be transferred on the wafer.

Preferably, a plurality of stacked thin films, e.g. rGO flakes layers, is placed into the carrier.

The system further comprises a pickup assembly.

The pickup assembly comprises a pickup arm.

The pickup arm is capable of switching between a lifted position and a lowered position.

The pickup assembly further comprises a pickup head.

The pickup head is configured to pick up a thin film from the carrier and subsequently deposit the thin film on the wafer.

The pickup assembly further comprises a motor.

The motor is configured to determine movement of the pickup arm between the lifted position and the lowered position.

The system further comprises a movement transmission means.

The movement transmission means is configured to move the base plate to a desired position.

For instance, the movement transmission means are operated to place the carrier under the pickup head for picking up a thin film from the carrier.

Similarly, the movement transmission means are operated to place the wafer holder under the pickup head, so that a thin film, held by the pickup head, can be deposited on the wafer.

The system further comprises a vacuum generating device.

For instance, the vacuum generating device may include one or more vacuum generating valves.

The system further comprises a controller.

The controller is configured to operate the vacuum generating device to generate a vacuum for holding the wafer in place on the wafer holder.

The invention is based on the basic idea that, by the provision of a transfer system as defined above, a thin film, e.g. a rGO flakes layer, can be transferred on a wafer with enhanced precision and reliability and minimal operator handling. System components of the transfer system are mostly or entirely software-controlled by software means running on the controller. Accordingly, transfer operations can be implemented with improved efficiency and accuracy, and minimal human intervention.

Additionally, the transfer system has a compact and simplified design, allowing for easier placement and maintenance.

Still further, the system may be enclosed by a protective casing, as described in detail in the following.

The system may further comprise a water pump.

In particular, said water pump is in fluid connection with a water reservoir.

Also, the system may comprise a water droplet application means.

Applying a water droplet on the wafer is important in order to allow for a proper adhesion of the thin film (e.g. a rGO flakes layer) on the wafer, e.g. without the occurrence of bubbles.

By the provision of a water droplet application means as defined above, a water droplet can be applied on the wafer in an easy and controlled manner.

The placement of a dry thin film such as a dry GO flakes layer on a wafer is known to be difficult, in specific circumstances it is almost impossible or even completely impossible.

Further, due to shrinking effects, the thin film may wrinkle when placed in a water droplet.

These effects, as result, may cause bad adhesion on the wafer and air bubbles.

According to the present disclosure, these points can be addressed by placing a wet layer of rGO flakes (on a filtering carrier) in a droplet of water on a wafer, so that the flakes will settle and adhere to the wafer without shrinking and/or wrinkling.

The present invention in particular discloses a means to carry out this placement of wet rGO flakes on a wafer.

The water droplet application means is in fluid connection with the water pump.

Here, the controller is further configured to:
operate the movement transmission means to position the wafer holder with the wafer under the water droplet application means, and
operate the water pump to apply a water droplet on the wafer through the water droplet application means.

The system may further comprise an air pump.

The air pump is provided with an airflow switch.

Accordingly, an airflow generated by the air pump can be directed in a desired airflow direction by operating the airflow switch.

For instance, an airflow from the air pump can be directed in a first airflow direction for holding the thin film in place in the pickup head for transfer.

Also, an airflow from the air pump can be directed in a second airflow direction for drying the wafer with the thin film deposited thereon.

In particular, in this configuration, the controller may be configured to:
operate the movement transmission means for positioning the carrier with the at least one thin film under the pickup head of the pickup assembly;
operate the motor of the pickup assembly to move the pickup arm from the lifted position toward the lowered position;
operate the air pump to generate an airflow in a first airflow direction for holding the thin film in place in the pickup head for transfer;
operate the motor of the pickup assembly to move the pickup arm from the lowered position toward the lifted position;
operate the movement transmission means to position the wafer holder with the wafer under the pickup head, and
operate the motor of the pickup assembly to control movement of the pickup arm from the lifted position toward the lowered position to transfer the thin film from the pickup head on the wafer.

Accordingly, the thin film, e.g. a rGO flakes layer, can be transferred on the wafer with enhanced ease, precision and reliability.

Also, after operating the movement transmission means to position the wafer holder with the wafer under the pickup head, the controller may be further configured to operate an additional vacuum generating device to generate a vacuum for removing water from the wafer.

This allows to easily remove any water residues from the wafer.

Also, this operation can be implemented in an automated manner, without requiring any manual intervention from an operator. This is beneficial to the overall level of precision. Also, the operator's convenience can be enhanced.

Moreover, the controller may be further configured to operate the airflow switch to direct an airflow from the air pump in a second airflow direction for drying the wafer with the thin film.

Accordingly, drying of the wafer with the thin film, e.g. a rGO flakes layer, can be easily accomplished, in an automated manner.

Still further, the controller may be configured to:
turn off the vacuum generating device and the air pump, and
operate the motor of the pickup assembly to control movement of the pickup arm from the lowered position toward the lifted position to allow for removal of the wafer from the wafer holder.

At this point, the transfer operation is completed.

Accordingly, the wafer can be removed from the wafer holder and the system can be controlled to start a new transfer operation.

The system further comprises a sensor means for inspection and measurement.

Software means can be implemented in the controller for measuring coordinates.

Accordingly, operation of the system (or components thereof) can be monitored with enhanced accuracy).

Preferably, the sensor means include a camera.

Images captured by the camera can be displayed on a display means.

The display means may be embedded in the transfer system.

Alternatively, the display means may be comprised in an external device, e.g., a laptop, tablet computer, or the like, operatively connected to the camera.

Conveniently, the base plate may comprise a plurality of base plate alignment pins.

The base plate alignment pins allow for correct positioning of the wafer holder on the base plate.

For example, said plurality of base plate alignment pins may include three alignment pins.

Here, two alignment pins are arranged at a front portion of the base plate, and one alignment pin is arranged on one side of the base plate.

This configuration has proven effective in order to allow for intuitively and reliably positioning the wafer holder on the base plate.

Conveniently, the wafer holder may comprise a plurality of wafer holder alignment pins to allow for correct positioning of the wafer on the wafer holder.

For example, said plurality of wafer holder alignment pins may include three alignment pins.

Here, two alignment pins are arranged at a front portion of the wafer holder, and one alignment pin is arranged on one side of the wafer holder.

This configuration has proven effective in order to allow for intuitively and reliably positioning a wafer on the wafer holder.

The wafer holder may be configured to hold a 4-inch wafer.

Alternatively, the wafer holder may be configured to hold a 6-inch wafer.

The system may further include a protective casing enclosing system components.

Accordingly, improved protection for the system component against potential damages and/or dust can be provided.

For instance, the protective casing may be in the shape of a box open on the front to allow access to the system components.

The protective casing may include aluminum profiles and clear walls, e.g., made of polycarbonate.

The sensor means for inspection and measurement, preferably a camera, may be integrated into the protective casing.

Accordingly, the sensor means, e.g., a camera, may be easily installed, without increasing the overall size of the system.

For instance, the sensor means, e.g., a camera, may be arranged on a top portion of the protective casing.

Conveniently, the system may further comprise a cable box for re-routing cables of the system.

This allows providing a proper protection for the cables against potential damage.

The invention further provides a wiping system for wiping a rim area of a thin film deposited on a wafer.

As a non-limiting example, the thin film can be a graphene-containing film.

In particular, the thin film can be a reduced graphene oxide (rGO) flakes layer.

The thin film may be deposited on the wafer by using the transfer system described in the foregoing.

The system comprises a base portion.

The system further comprises a wafer holder.

The wafer holder is arranged on the base portion.

The wafer holder is configured to hold a wafer with at least one thin film deposited on one surface.

Similar as above, the wafer holder may be configured to hold a 4-inch wafer.

Alternatively, the wafer holder may be configured to hold a 6-inch wafer.

The system further comprises a wiping assembly.

The wiping assembly comprises a wiping device.

The wiping device comprises a handle and a head paddle.

The head paddle is made of a flexible material, e.g., nylon.

In particular, the head paddle serves as a soft brush for wiping a rim area of the thin film.

Wiping devices of this kind are well-known in the art.

The wiping assembly further comprises a wiping device holder.

The wiping device holder is configured for connection to the handle, to maintain the wiping device in place for use.

The wiping assembly further comprises a motor.

The motor is configured for controlling operation of the wiping device.

In particular, the motor is configured to operate the wiping device for wiping a rim area of the thin film, and stop operation of the wiping device once wiping is completed.

The system further comprises a wiping assembly arm.

The wiping assembly arm is connected to the wiping assembly.

The wiping assembly arm is configured to switch between a lifted position and a lowered position.

For instance, the wiping assembly can be manually switched by the user between the lifted position and the lowered position.

Alternatively, a mechanism including a motor can be provided to determine movement of the wiping assembly between the lifted position and the lowered position.

By the provision of a wiping system as defined above, wiping of the rim area of a thin film, e.g. a rGO flakes layer deposited on a wafer can be performed with enhanced precision and accuracy, and minimal operator handling. Also, lengthy and burdensome operations required by manual wiping can be avoided.

Conveniently, the system may further comprise a vacuum generating device.

The vacuum generating device is configured to generate a vacuum to maintain the wafer in place on the wafer holder during operation.

The vacuum generating device operates in the same manner as the vacuum generating device of the transfer system described above.

Accordingly, the wafer is reliably held on the wafer holder during operation.

The wiping assembly may further comprise a tubular component made of a flexible material.

Advantageously, the tubular component can be made of silicon.

The tubular component is connected to the handle of the wiping device.

Also, the tubular component is configured for connection to the wiping device holder.

By connecting the wiping device to the wiping device holder through the tubular component, a more flexible configuration can be obtained.

Conveniently, the system may further comprise a camera.

Accordingly, operation of the system (or components thereof) can be monitored with enhanced accuracy.

Preferably, the camera is mounted on a support.

Preferably, the support comprises a camera adjustment means for adjusting a position of the camera.

Accordingly, a position of the camera can be tuned according to the needs.

Conveniently, the system may further comprise a wiping device adjustment means.

The wiping device adjustment means allows for adjustment of a position of the wiping device.

Preferably, the wiping device adjustment means comprises a height adjustment means for adjusting a height of the wiping device with respect to the wafer holder.

Additionally or alternatively, the wiping device adjustment means may comprise a fine-adjustment means for tuning orientation of the wiping device.

Accordingly, positioning of the wiping device can be adjusted with improved accuracy and precision.

The base portion may comprise at least one base portion alignment pin.

The at least one base portion alignment pin may be configured for engagement with a corresponding at least one alignment hole formed on a surface of the wafer holder.

Accordingly, the wafer holder can be easily and intuitively placed on the base portion and reliably maintained in place during operation.

The wiping system may be integrated into the transfer system described above.

Accordingly, a single, integrated system can be obtained.

The transfer system described above is suitable for use in a method of transferring a thin film on a wafer.

As a non-limiting example, the thin film can be a graphene-containing film.

In particular, the thin film can be a reduced graphene oxide (rGO) flakes layer.

In one example, the method comprises:
providing at least one thin film, e.g. a rGO flakes layer, into the carrier;
providing a wafer on the wafer holder;
operating the vacuum generating device to generate a vacuum for holding the wafer in place on the wafer holder;
operating the movement transmission means to position the wafer holder with the wafer under the water droplet application means;
operating the water pump to apply a water droplet on the wafer through the water droplet application means;
operating the movement transmission means for positioning the carrier with the at least one thin film under the pickup head of the pickup assembly;
operating the motor of the pickup assembly to move the pickup arm from the lifted position toward the lowered position;
operating the air pump to generate an airflow in a first airflow direction for holding the thin film in place within the pickup head for transfer;
operating the motor of the pickup assembly to control movement of the pickup arm from the lowered position toward the lifted position;
operating the movement transmission means to position the wafer holder with the wafer under the pickup head;
operating an additional vacuum generating device to generate a vacuum for removing water from the wafer;
operating the motor of the pickup assembly to move the pickup arm from the lifted position toward the lowered position to transfer the thin film from the pickup head on the wafer;
operating the airflow switch to direct an airflow from the air pump in a second airflow direction for drying the wafer with the thin film for a predetermined period of time, preferably for 5 minutes;
turning off the vacuum generating device and the air pump;
moving the pickup arm from the lowered position toward the lifted position to allow for removal of the wafer from the wafer holder, and
removing the wafer from the wafer holder.

Conveniently, the step of providing at least one thin film into the carrier comprises providing a plurality of stacked thin films, e.g. rGO flakes layers, into the carrier with an adhesive tape or an adhesive stripe interposed therebetween.

Operation of the transfer system components is mostly or entirely software-controlled.

In particular, a computer-readable non-volatile storage medium can be provided, said storage medium comprising computer-readable instructions that, when executed by a processing means, causes said processing means to implement and/or process and/or perform the method steps defined above.

The wiping system described above is suitable for use in a method of wiping a rim area of a thin film deposited on a wafer.

As a non-limiting example, the thin film can be a graphene-containing film.

In particular, the thin film can be a reduced graphene oxide (rGO) flakes layer.

In one example, the thin film, e.g. a rGO flakes layer, is deposited on the wafer using the transfer system described in the foregoing, for instance by implementing the transfer method described in the foregoing.

In one example, the method comprises:
placing the wafer holder on the base portion;
placing the wafer with the at least one thin film, e.g. a rGO flakes layer, on the wafer holder;
connecting the wiping device to the wiping device holder;
optionally adjusting height and/or orientation of the wiping device with respect to the wafer holder;
moving the wiping assembly arm from a lifted position toward a lowered position;
controlling the motor of the wiping assembly to operate the wiping device to wipe a rim area of the thin film;
when wiping is completed, controlling the motor to stop operation of the wiping device;
moving the wiping assembly arm from the lowered position toward the lifted position, and
removing the wafer from the wafer holder.

Operation of the wiping system components is mostly or entirely software-controlled.

In particular, a computer-readable non-volatile storage medium can be provided, said storage medium comprising computer-readable instructions that, when executed by a processing means, causes said processing means to implement and/or process and/or perform the method steps defined above.

Further details and advantages of the invention will now be disclosed in connection with the drawings, where:
- **Fig. 1**: shows a perspective view of a transfer system for transferring a thin film, especially a graphene-containing film, e.g. a rGO flakes layer, according to an embodiment of the invention;
- **Fig. 2**: shows the arrangement of a base plate and a wafer holder in the system of **Fig 1****.** The wafer holder is arranged on the base plate. A wafer is placed and secured on the wafer holder;
- **Figs. 3a-b**: show different views of the wafer holder of **Fig. 2** and its alignment pins. In detail: **a.** wafer holder. Here, the wafer holder includes three alignment pins, two arranged at a front portion of the holder, and one on its left side; **b.** same wafer holder as in **a.,** but with a wafer placed on it; **c.** similar arrangement as in **b.,** but where one of the alignment pins is provided on the right side of the holder, instead of the left side as in **b.;**
- **Fig. 4**: shows a detail of a X-home sensor of the system of **Fig. 1****;**
- **Fig. 5**: shows a detail of a rotation-home sensor of the system of **Fig. 1****;**
- **Fig. 6**: shows a detail of a switch-home sensor of the system of **Fig. 1****;**
- **Fig. 7**: shows a detail of a Z-home sensor of the system of **Fig. 1****;**
- **Fig. 8**: shows a protection casing enclosing system components of the system of **Fig. 1****.** A cable box is also provided for re-routing system cables. The cable box is arranged on a bottom portion of the casing;
- **Fig. 9**: provides a view that is similar to that of **Fig. 8****,** but where a sensor means for inspection and measurements, here a camera, is integrated into the protective casing. In particular, the camera is arranged on a top portion of the casing;
- **Fig. 10**: shows an image captured by the camera, displayed on a display means;
- **Fig. 11**: shows another image captured by the camera, with a closer zoom;
- **Figs. 12a-c**: show details of electronic components of the system of **Fig. 1****,** arranged in a control box. In detail: **a.** electronic components of the system, in particular motor drivers and CNC board; **b.** electronic components of the system as in **a.,** enclosed in a control box. Here, a top portion of the box is removed; **c.** control box enclosing electronic components of the system;

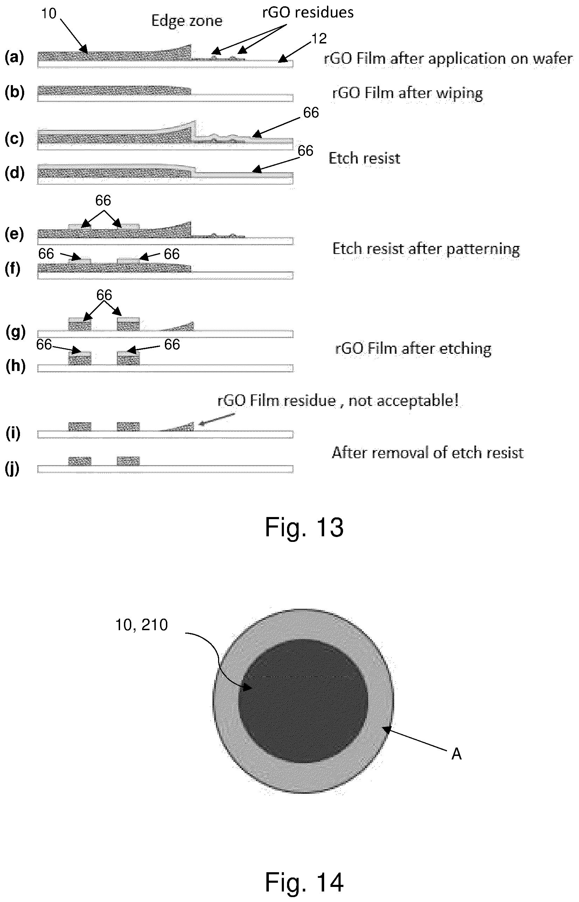

- **Figs. 13a-j**: are diagrams showing respective cross-section views of the edge zone of a thin film, here a rGO flakes layer, transferred on a wafer, after implementing a patterning process and an etching process in two different scenarios. In detail: **a.** edge zone of a thin film, here a rGO flakes layer after transfer on a wafer. Here, a rim area of the rGO flakes layer has an increased thickness and a sharp edge. Also, rGO residues may be present nearby the rim area; **b.** edge zone of a rGO flakes layer transferred on a wafer, after an appropriate wiping operation. The rim area shows a reduced thickness compared to **a.** Moreover, residues, e.g. rGO residues, are no longer present nearby the rim area. Also, the rim area shows no sharp edges. **c.** etch resist applied on the rGO flakes layer in the scenario of **a.; d.** etch resist applied on the rGO flakes layer in the scenario of **b.; e.** etch resist on the rGO flakes layer after patterning, in the scenario of **a.; f.** etch resist on the rGO flakes layer after patterning, in the scenario of **b.; g.** rGO flakes layer after etching, in the scenario of **a.; h.** rGO flakes layer after etching, in the scenario of **b; i.** edge area of the rGO flakes layer after removal of the etch resist at the completion of the etching process, in the scenario of **a.** As shown in the figure, rGO residues are still present nearby the rim area, which is not acceptable; **j.** edge area of the rGO flakes layer after removal of the etch resist at the completion of the etching process, in the scenario of **b.** Here, no rGO residues are present nearby the rim area, as a result of the wiping operation after transferring;
- **Fig. 14**: shows the rim area of a thin film, here a rGO flakes layer (see gray area denoted with A in the figure) that shall be subject to a wiping operation after being deposited on a wafer to reduce edge thickness and remove possible rGO residues in the surroundings;
- **Fig. 15**: shows a perspective view of a wiping system for wiping a rim area of a thin film, especially a graphene-containing film, e.g. a reduced graphene oxide (rGO) flakes layer, on a wafer, according to an embodiment of the invention;
- **Fig. 16**: shows a view that is similar to that of **Fig. 15****,** but from a different perspective;

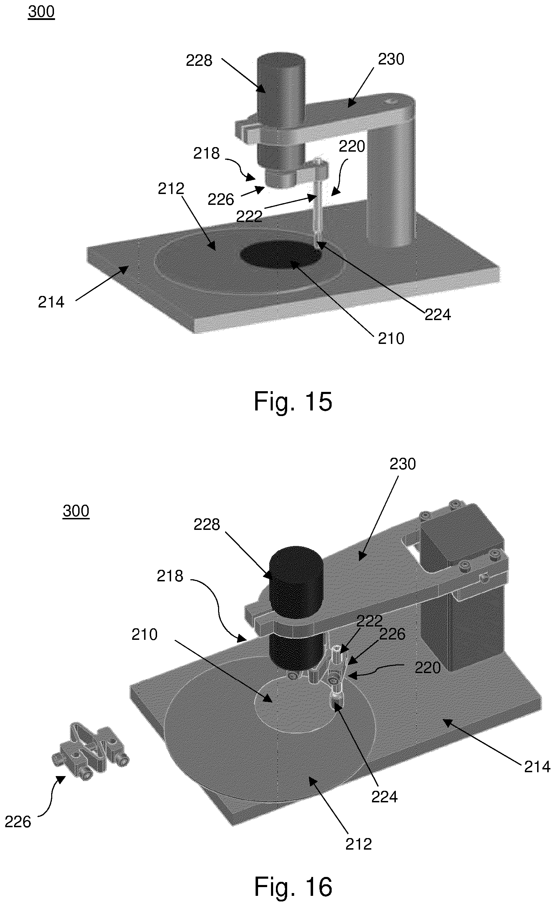

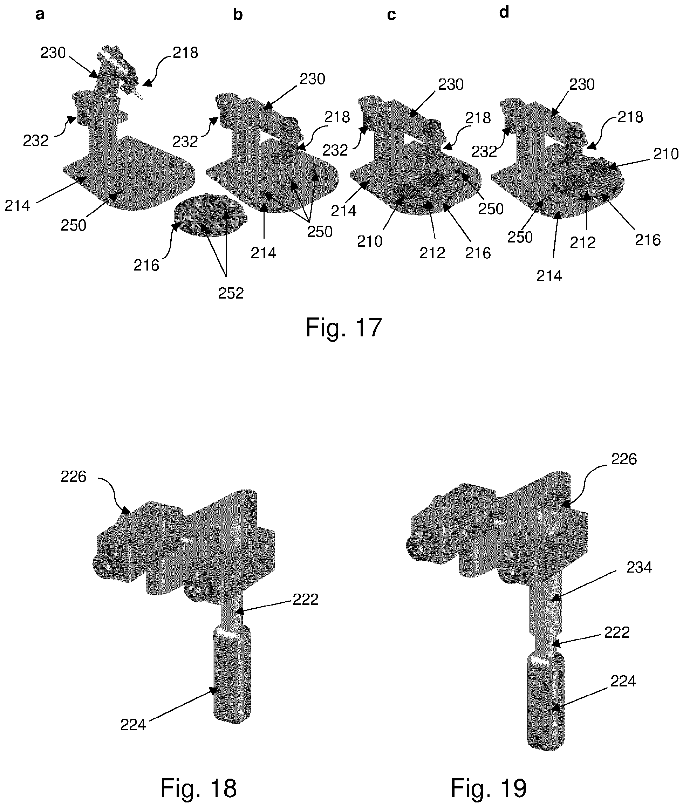

- **Figs. 17a-d**: show an exemplary operation of the wiping system of **Fig. 15****.** The system comprises a wiping assembly including a wiping device, a wiping device holder, and a motor for controlling operation of the wiping device. A wiping assembly arm is connected to the wiping assembly and is adapted for moving between a lifted position and a lowered position. In detail: **a.** resting state before use. Here, the arm is in the lifted position; **b.** a wafer holder is provided, and the arm is moved to the lowered position for use. A base portion of the system includes alignment pins for corresponding alignment holes formed on a surface of the wafer holder; **c.** the wafer holder is placed and secured on the base portion in a first operative position, and a wafer holding one or more (here, two) thin films (e.g., rGO flakes layers) is placed on the wafer holder. A vacuum device is operated to hold the wafer in place on the wafer holder during operation. Eventually, the wiping device is operated for wiping the rim area of a first one of the thin films; **d.** after wiping of the first thin film is completed, operation of the wiping device is stopped. The wafer holder is then moved to a second operative position, for wiping the rim area of the second thin film. This is carried out in the same way described in **c.** with respect to the first thin film. Once wiping of the rim area of the second thin film is accomplished, the arm is moved to the lifted position as in **a.,** and the wafer is removed from the wafer holder;
- **Fig. 18**: shows a detail of the wiping device connected to the wiping device holder. The wiping device comprises a handle and a head paddle, e.g., made of nylon. For use, the handle is connected to the wiping device holder;
- **Fig. 19**: is a view that is similar to that of **Fig. 18****,** but where the wiping assembly further comprises a tubular component made of a flexible material, e.g., silicon, connected to the handle. The flexible tubular component is configured for connection to the wiping device holder, thereby providing a more flexible configuration;
- **Fig. 20**: shows residues, in particular rGO residues, on a tip portion of a head paddle after completion of a wiping operation using the wiping system of **Fig. 15****;**
- **Fig. 21**: shows a detail of a camera setup for use in the wiping system of **Fig. 15****.** The camera is arranged on a support. A camera adjustment means, here including a lever, is provided in the support for adjusting a position of the camera. Here, the camera adjustment means includes a lever;
- **Fig. 22**: is a view that is similar to that of **Fig. 21****,** but where the adjustment means has a different configuration, in particular including an adjustment screw;
- **Fig. 23**: shows different views of the camera, taken from below, with or without a diffusor. The camera includes a plurality of LEDs to illuminate an object. Due occurring reflections, each LED defines a light spot. By adding a diffusor in front of the LEDs, a more homogeneous light can be provided;
- **Figs. 24a-b**: show different images captured by the camera, here focused on a central pin of the base portion of the wiping system. The central pin serves as an alignment for the wafer holder. In detail: **a.** maximum distance; **b.** minimum distance (i.e., maximum zoom);
- **Figs. 25a-b**: show details of a wiping device adjustment means. In detail: **a.** camera support as in **Fig. 21****,** including a wiping device adjustment means (see emphasized area); **b.** detail of the wiping device adjustment means. Here, the wiping device adjustment means includes a height adjustment means for adjusting a height of the wiping device with respect to the wafer holder, and a fine adjustment means for tuning orientation of the wiping device;
- **Fig. 26**: shows a wiping system, such as the wiping system of **Fig. 15****,** integrated into the transfer system of **Fig. 1** to form a single, integrated system;
- **Figs. 27a-f**: show an alternative configuration for the wafer holder, in particular provided with a clamping means, and its functioning;
- **Figs. 28a-c**: schematically show a solution for removal of the carrier from the wafer after a thin film, e.g. a layer of rGO flakes, is placed on the wafer. Here, a paper disc having an adhesive, e.g. a double-sided adhesive tape, is used for the purpose;
- **Fig. 29**: shows an alternative solution to the one shown in **Figs. 28a****-c,** where a stripe, e.g. a paper stripe, is used instead of the paper disc.
- **Figs. 30a-c**: shows a stack of paper sheets and a transfer carrier used to perform a placement accuracy test. In particular: **a.** stack of paper sheets arranged in the transfer carrier. **b** a 3mm reamer used to form the center hole in the paper sheets; **c.** different views of the paper sheets and the transfer carrier.
- **Fig. 31**: shows an experimental setup for the placement accuracy test;
- **Figs. 32a-b**: show exemplary test wafers for use in the experimental setup of **Fig. 31****.** In detail: **a.** 4-inch test wafer. **b.** 6-inch test wafer.
- **Fig. 33**: shows images captured by a camera during test, used for measuring placement accuracy;
- **Fig. 34**: shows an experimental setup for a water dosing accuracy test;
- **Fig. 35**: shows the results of a water dosing accuracy test carried out by using the experimental setup of **Fig. 34****,** implemented in the system of **Fig. 1****.** The test set-up included 5 runs, with 9 droplets each.

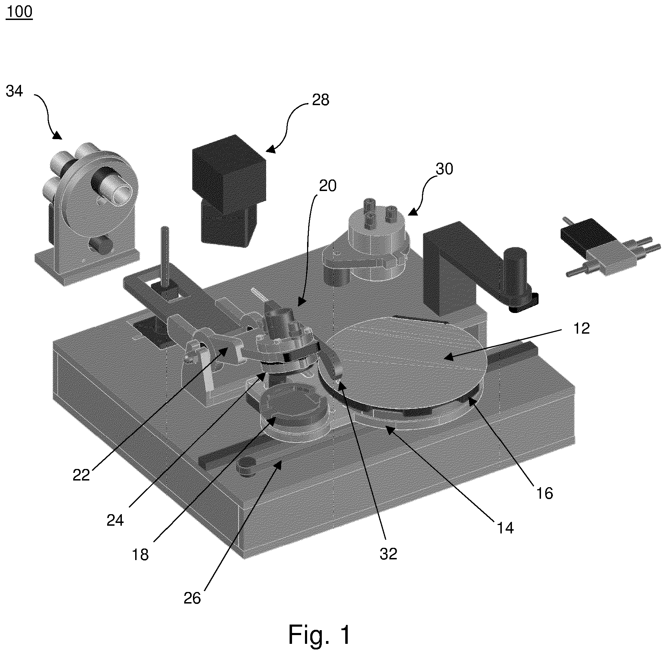

**Fig. 1** shows a transfer system 100 for transferring a thin film 10 on a wafer 12 according to an embodiment of the invention.

As a non-limiting example, the thin film 10 can be a graphene-containing film.

In the present embodiment, the thin film 10 is a layer 10 of reduced graphene oxide (rGO) flakes.

However, the invention is not to be considered limited to a solution where the thin film 10 is a layer of rGO flakes.

By contrast, other materials can be used, provided that they are suitable for the purpose.

The system 100 comprises a base plate 14.

The system 100 further comprises a wafer holder 16 configured to hold a wafer 12.

The wafer holder 12 is arranged on the base plate 14.

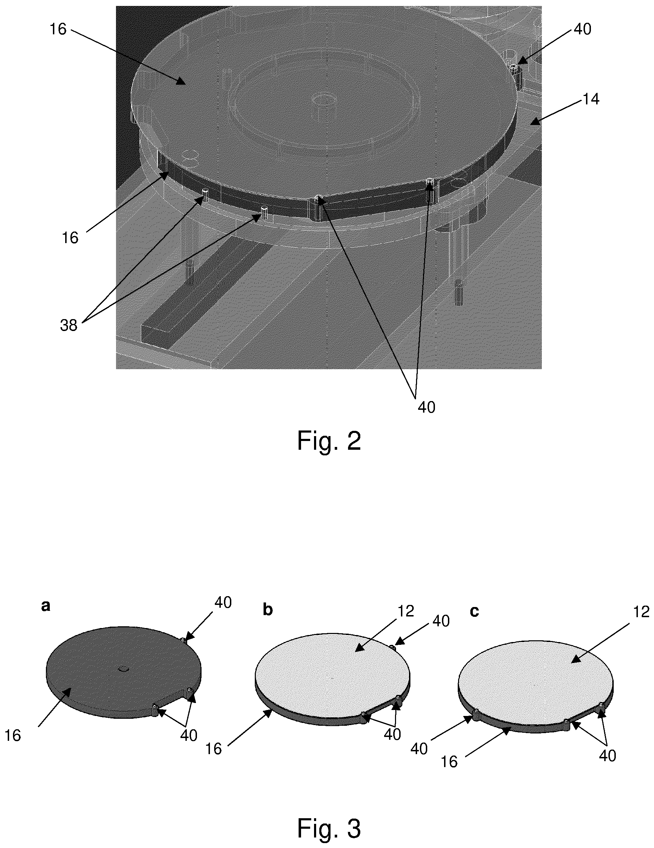

In the present embodiment, as shown in **Fig. 2****,** the base plate 14 comprises a plurality of base plate alignment pins 38 to allow for correct positioning of the wafer holder 16 on the base plate 14.

In particular, in the present embodiment, the base plate 14 comprises three alignment pins 38, two arranged at a front portion of the base plate 14, and one arranged on one side of the base plate 14 **(****Fig. 2****).**

In the present embodiment the wafer holder 16 comprises a plurality of wafer holder alignment pins 40 to allow for correct positioning of the wafer 12 on the wafer holder 16.

The wafer holder 16 and its alignment pins 40 are shown in detail in **Fig. 3(a)****.**

**Figs. 3(b)****-(c)** show the wafer holder 16 while holding a wafer 12.

The wafer holder 16 may be configured to hold a 4-inch wafer.

Alternatively, the wafer holder 16 may be configured to hold a 6-inch wafer.

In both cases, the wafer holder 16 has the same structure, only varying in its dimension.

In the present embodiment, as shown in **Figs. 2-3****,** the plurality of wafer holder alignment pins 40 include three alignment pins 40, wherein two alignment pins 40 are arranged at a front portion of the wafer holder 16, and one alignment pin 40 is arranged on one side of the wafer holder 16.

For example, two alignment pins 40 may be arranged at the front portion of the holder 16, while one pin can be arranged at its left side, as shown in **Fig. 3(b)****.**

Alternatively, two alignment pins 40 may be arranged at the front portion of the holder 16, while one pin can be arranged at its right side, as shown in **Fig. 3(c)****.**

The system 100 further comprises a carrier 18 for at least one rGO flakes layer 10 to be transferred on the wafer 12.

Preferably, a stack of rGO flakes layers 10 (not shown in **Fig. 1****)** is provided into the carrier 18.

In particular, one or more layers 10 of rGO flakes can be placed on the carrier 18 and subsequently picked up from the carrier 18 and transferred on the wafer 12.

The system 100 further comprises a pickup assembly 20.

As shown in **Fig. 1****,** the pickup assembly 20 comprises:
a pickup arm 22;
a pickup head 24, configured to pick up a rGO flakes layer 10 from the carrier 18 and subsequently deposit the rGO flakes layer 10 on the wafer 12, and
a motor, configured to determine movement of the pickup arm 22 between a lifted position and a lowered position.

When the pickup arm 22 is moved from the lifted position toward the lowered position, and *vice versa,* the pickup head 24 is moved accordingly.

The system 100 further comprises a movement transmission means 26, configured to move the base plate 14 to a desired position.

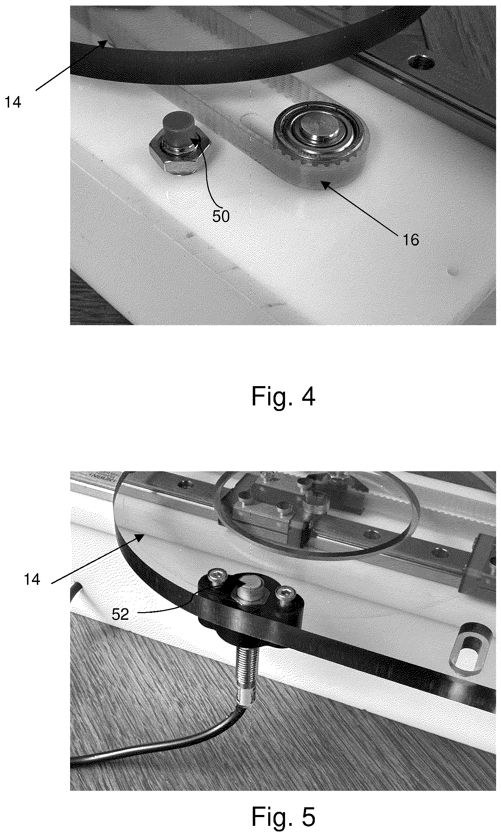

The movement transmission means 26 may include a transmission belt **(****Figs. 1** and **4****).**

Not shown is that a different configuration for the movement transmission means is also possible according to the invention.

The movement transmission means 26 are operated to position the carrier 18 under the pickup head 24, so that a rGO flakes layer 10 in the carrier 18 can be picked up by the pickup head 24 for transfer.

Also, the movement transmission means 26 is operated to position the wafer holder 16 with the wafer 12 under the pickup head 24, so that a rGO flakes layer 10, held by the pickup head 24, can be deposited on the wafer 12.

The system 100 further comprises a vacuum generating device (not shown).

Moreover, the system 100 comprises a controller (not shown).

The controller is configured to operate the vacuum generating device to generate a vacuum for holding the wafer 12 in place on the wafer holder 16.

In the present embodiment, the vacuum generating device comprises at least one vacuum generating valve.

As mentioned, the vacuum generating device is controlled to generate a vacuum for maintaining the wafer 12 in place on the wafer holder 16 during operation of the system 100.

Also, an additional vacuum generating device is provided and controlled by the controller to generate a vacuum for removing water from the wafer 12.

In the present embodiment, the system 100 further comprises a water pump 28, in fluid connection with a water reservoir 30.

For instance, the water pump 28 may be connected to the water reservoir 30 through one or more pipes and water-tight connectors.

In the present embodiment, the system 100 further comprises a water droplet application means 32 in fluid connection with the water pump 28.

For instance, the water droplet application means 32 may be connected to the water pump 28 through a pipe and water-tight connectors.

The water droplet application means 32 is configured to apply a water droplet on the wafer 12 upon being operated.

In particular, the controller is configured to:
operate the movement transmission means 26 to position the wafer holder 16 with the wafer 12 under the water droplet application means 32, and
operate the water pump to apply a water droplet on the wafer 12 through the water droplet application means 32.

In the present embodiment, the system 100 further comprises an air pump (not shown) provided with an airflow switch 34.

Accordingly, an airflow generated by the air pump can be directed in a desired airflow direction.

The air pump is in fluid connection with the pickup head 24.

An airtight pipe can be used for this purpose.

The airflow switch 34 is operated so that an airflow from the air pump is directed in a first airflow direction for holding the rGO flakes layer 10 in place in the pickup head 24 for transfer.

Also, the airflow switch 34 is operated to direct an airflow from the air pump in a second airflow direction for drying the wafer 12 with deposited rGO flakes layer(s) 10.

In particular, the controller is configured to:
operate the movement transmission means 26 for positioning the carrier 18 with the at least one rGO flakes layer 10 under the pickup head 24 of the pickup assembly 20;
operate the motor of the pickup assembly 20 to move the pickup arm 22 from the lifted position toward the lowered position;
operate the air pump to generate an airflow in a first airflow direction for holding the rGO flakes layer 10 in place in the pickup head 24 for transfer;
operate the motor of the pickup assembly 20 to move the pickup arm 22 from the lowered position toward the lifted position;
operate the movement transmission means 26 to position the wafer holder 16 with the wafer 12 under the pickup head 24, and
operate the motor of the pickup assembly 20 to control movement of the pickup arm 22 from the lifted position toward the lowered position to transfer the rGO flakes layer 10 from the pickup head 24 on the wafer 12.

After operating the movement transmission means 26 to position the wafer holder 16 with the wafer 12 under the pickup head 24, the controller is further configured to operate the additional vacuum generating device to generate a vacuum for removing water from the wafer 12.

The controller is also configured to operate the airflow switch 34 to direct an airflow from the air pump in a second airflow direction for drying the wafer 12 with the rGO flakes layer 10.

Moreover, the controller is further configured to:
turn off the vacuum generating device and the air pump, and
operate the motor of the pickup assembly 20 to control movement of the pickup arm 22 from the lowered position toward the lifted position to allow for removal of the wafer 12 from the wafer holder 16.

At this point, the transfer operation is accomplished. The wafer 12 can be removed from the wafer holder and the system 100 can be controlled to start another transfer operation.

Sensor can be provided in the system 100 for monitoring operation of one or more system components.

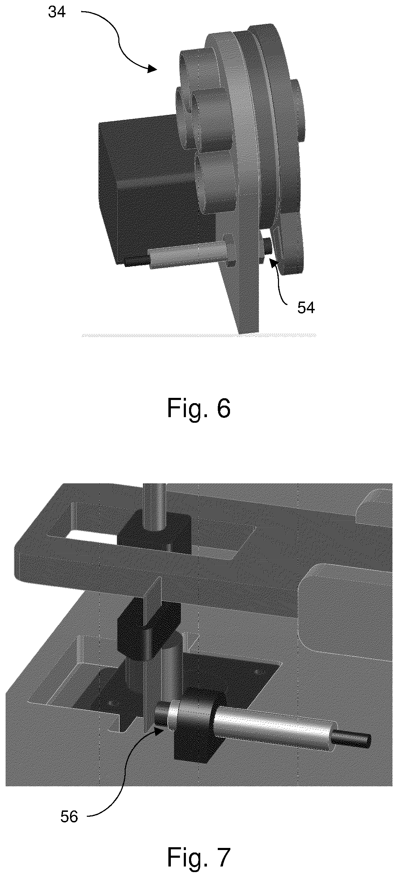

For example, the system 100 may be provided with one or more among a X-home sensor 50 (Fig. 4), a rotation-home sensor 52 (Fig. 5), and air switch-home sensor 54 (Fig. 6), and a Z-home sensor 56 **(****Fig. 7****).**

The use of different sensors in addition or as an alternative to the ones listed above is also possible according to the invention.

In the present embodiment, the system 100 comprises a sensor means 36 for inspection and measurement.

In the present embodiment, said sensor means 36 for inspection and measurement comprises a camera 36.

Software means can be implemented in the controller for measuring coordinates.

In the present embodiment, the system 100 comprises a protective casing 42 enclosing components of the system 100.

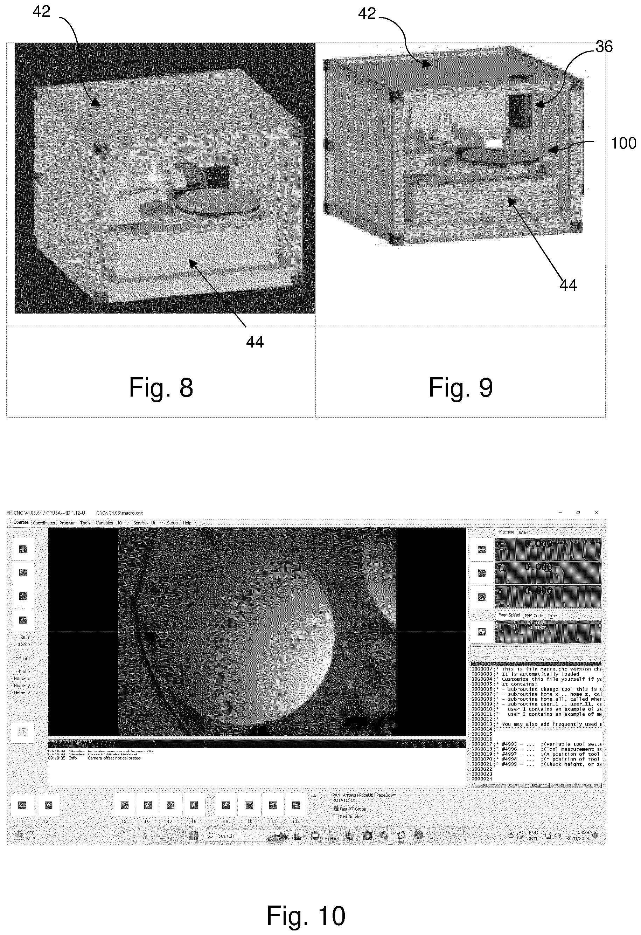

The protective casing 42 is shown in detail in **Fig. 8****.**

Here, the protective casing 42 is in the shape of a box open on the front to allow accessing the system components.

In the present embodiment, the protective casing 42 comprises aluminum profiles and clear walls, e.g., made of polycarbonate.

In the present embodiment, the camera 36 is integrated into the protective casing 42.

In particular, the camera 36 is arranged on a top portion of the protective casing 42, as shown in **Fig. 9****.**

An exemplary image captured by the camera 36 is shown in **Fig. 10****.**

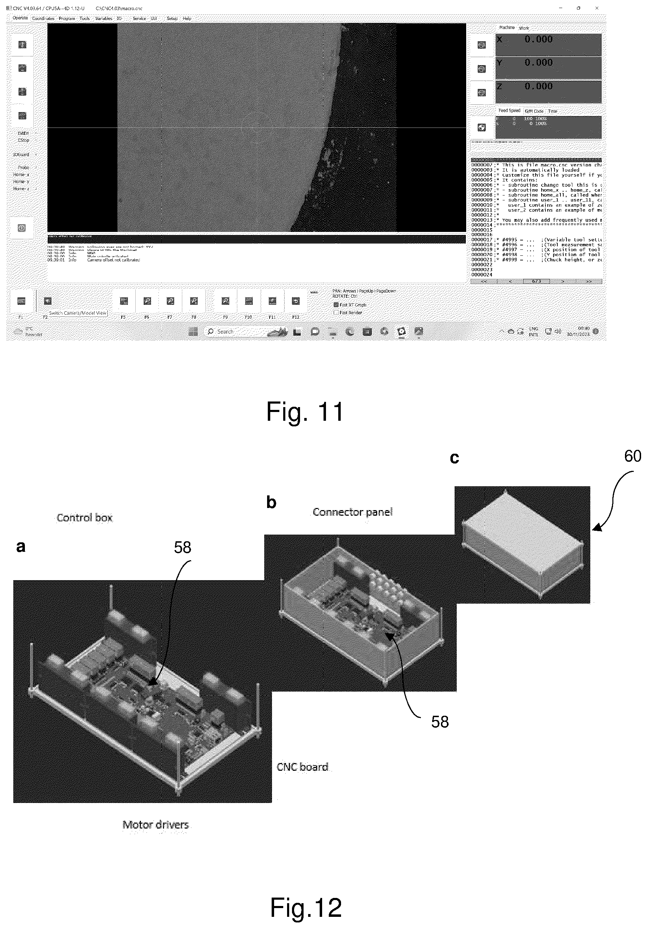

**Fig. 11** shows an image that is similar to that of **Fig. 10****,** but with a closer zoom.

Images captured by the camera are displayed on display means (not shown).

The display means, e.g., a monitor, may be embedded in the system 100.

Alternatively, the display means can be comprised in an external device, e.g., a laptop, tablet computer, or the like, operatively connected to the camera 36.

In the present embodiment, the system 100 comprises a cable box 44 for re-routing cables of the system 100.

The cable box 44 can be arranged on a bottom portion of the protective casing 42 **(****Figs. 8-9****).**

In the present embodiment, electronic components 58 of the system 100 (schematically illustrated in **Figs. 12(a)****-(b)),** e.g. including motor drivers and a CNC board, are arranged within a control box 60 **(****Fig. 12(c)****).**

Operation of the transfer system 100 components is mostly or entirely software-controlled, thus requiring minimum human intervention.

After a thin film 10, here a rGO flakes layer 10, is transferred on a wafer 12, e.g. through the system 100 described above, a patterning process and a subsequent etching process are implemented.

A etch resist 66 is applied on the rGO flakes layer 10 before patterning (as shown, e.g., in **Figs. 13(c)****-(d)** described below).

The etch resist 66 is removed from the rGO flakes layer 10 after the etching process is accomplished. As schematically illustrated in **Fig. 13(a)****,** a rim area of a thin film 10, here a rGO flakes layer 10, deposited on the wafer 12, may show an increased thickness and sharp edges.

Also, rGO residues may be present nearby the rim area of the rGO flakes layer 10 **(****Fig. 13(a)****).**

These conditions are undesirable and shall be addressed.

To this end, a wiping operation is required in order to reduce thickness and smoothen sharp edges in the rim area of the rGO flakes layer 10, further than removing possible rGO residues nearby the rim area.

**Fig. 13(b)** shows the rGO flakes layer 10 on the wafer 12 after a successful wiping operation.

Here, thickness of the rim area is reduced, and residues are removed from the surroundings. Also, the rim area does no longer include sharp edges.

**Figs. 13(c)****-(d)** show an etch resist 66 applied on the rGO flakes layer 10, in both scenarios of **Figs. 13(a)****-(b).**

**Figs 13(e)****-(f)** shows the etch resist 66 on the rGO flakes layer 10 after completion of a patterning operation, in both scenarios of **Figs. 13(a)****-(b).**

Eventually, **Figs. 13(g)****-(h)** show the rGO flakes layer after etching, in both scenarios of **Figs. 13(a)****-(b).**

After completion of the etching process, the etch resist 66 is removed from the rGO flakes layer 10.

**Figs. 13(i)****-(j)** show the edge area of the rGO flakes layer 10 after removal of the etch resist 66 at the end of the etching process.

It may be noted that, in case no wiping operation is implemented after the rGO flakes layer 10 is transferred on the wafer 12 **(****Fig. 13(a)****),** rGO residues may still be present after patterning and etching, as schematically illustrated in **Fig. 13(i)****,** which is not acceptable.

Conversely, in a case a successful wiping operation is carried out after transferring the rGO flakes layer 10 on the wafer 12, rGO residues are no longer present nearby the rim area **(****Fig. 13(j)****).**

This confirms the importance of implementing an accurate wiping operation after transferring the rGO flakes layer 10 on the wafer 12, thus reducing increased thickness, smoothening any sharp edges, and removing rGO residues that might be present nearby the rim area.

**Fig. 14** schematically shows a rim area of a thin film, here a rGO flakes layer 10, 210 (see gray area denoted with A) which needs to be subject to wiping after deposition on a wafer to reduce edge thickness and remove possible rGO residues.

**Figs. 15-16** show different views of a wiping system 300 for wiping a rim area of a of a thin film 210 deposited on a wafer 212, according to an embodiment of the present invention.

In the present embodiment, the thin film 210 is a rGO flakes layer 210.

In particular, the rGO flakes layer 210 is the same as the rGO flakes layer 10 described above.

Similarly, the wafer 212 is the same as the wafer 12 described above.

The system 300 comprises a base portion 214.

The system 300 further comprises a wafer holder 216 configured to hold a wafer 212 with at least one rGO flakes layer 210 deposited on one surface.

The wafer holder 216 is arranged on the base portion 214.

The wafer holder 216 is structurally similar to the wafer holder 16 described above.

The wafer holder 216 may be configured to hold a 4-inch wafer.

Alternatively, the wafer holder 216 may be configured to hold a 6-inch wafer.

In both cases, the wafer holder 216 has the same structure, only varying in dimension.

In the present embodiment, as shown in **Fig. 17****,** the base portion 214 comprises at least one base portion alignment pin 250 configured for engagement with a corresponding at least one alignment hole 252 formed on a surface of the wafer holder 216.

Accordingly, the wafer holder 216 can be easily and intuitively positioned on the base portion 214 and reliably maintained in place during operation of the system 300.

Preferably, the base portion 214 comprises a plurality of alignment pins 250 (three, in the configuration of **Fig. 17****)** adapted for engagement with corresponding alignment holes 252 of the wafer holder 216.

In the present embodiment, the system 300 includes a vacuum generating device 232 configured to generate vacuum to maintain the wafer 212 in place on the wafer holder 216 during operation **(****Fig. 17****).**

The vacuum generating device 232 operates in the same manner as the vacuum device of the system 100 described above.

The system 300 comprises a wiping assembly 218.

The wiping assembly 218 includes:
a wiping device 220;
a wiping device holder 226, and
a motor 228 for controlling operation of the wiping device 220.

**Fig. 18** shows a detail of the wiping device 220 connected to the wiping device holder 226.

The wiping device 220 comprises a handle 222 and a head paddle 224 made of a flexible material, e.g., nylon.

The head paddle 224 serves as a soft brush for wiping a rim area of the thin film 210, here a rGO flakes layer 210.

Wiping devices of this kind are well-known in the art.

The size of the head paddle 224 (e.g., the diameter) is selected based on the pressure that needs being applied during operation.

Conveniently, the motor 228 can be a DC motor.

In the configuration of **Fig. 18****,** the wiping device holder 226 is connected to the handle 222 of the wiping device 220, to maintain the wiping device 220 in place for use.

This solution provides a quite stiff configuration.

An alternative solution is shown in **Fig. 19****.**

Here, the wiping assembly 218 further comprises a tubular component 234 made of a flexible material.

For example, the tubular component 234 can be made of silicon.

The tubular component 234 is connected to the handle 222, and is configured for connection to the wiping device holder 226.

By connecting the wiping device holder 226 to the tubular component 234 (rather than directly to the handle 222), a higher flexibility can be obtained.

The system 300 further comprises a wiping assembly arm 230.

The wiping assembly arm 230 is configured to switch between a lifted position and a lowered position.

When the wiping assembly arm 230 is moved from the lifted position toward the lowered position, and *vice versa,* the wiping assembly 218 is moved accordingly.

Operation of the wiping system 300 is schematically illustrated, by way of a non-limiting example, in **Fig. 17****.**

Here, the wafer 212 includes two rGO flakes layers 210.

The wafer holder 216 comprises two alignment holes 252.

In particular, each of the alignment holes 252 is formed under the center of a respective one of the rGO flakes layers 210.

A wafer including a single rGO flakes layer 210 or more than two rGO flakes layers 210 can also be used.

In a resting state of the system 300, the wiping assembly arm 232 is in a lifted position **(****Fig. 17(a)****).**

The wafer holder 216 is provided, and the wiping assembly arm 230 is moved to the lowered position for use **(****Fig. 17(b)****).**

The wafer holder 216 is placed on the base portion 214 in a first operative position, and the wafer 212 is placed on the base portion 214 **(****Fig. 17(c)****).**

Then, the wiping device 220 is operated for wiping the rim area of the first thin film 210, here a rGO flakes layer 210.

Once wiping of the rim area of the first rGO flakes layer 210 is completed, the wafer holder 216 is moved to a second operative position on the base portion 214, and the wiping device 220 is operated for wiping the rim area of the second rGO flakes layer 210 **(****Fig. 17(d)****).**

Once wiping of the rim area of the second rGO flakes layer 210 is accomplished, the wiping assembly arm 232 is moved to the lifted position (as illustrated in **Fig. 17(a)****),** and the wafer 212 is removed from the wafer holder 216.

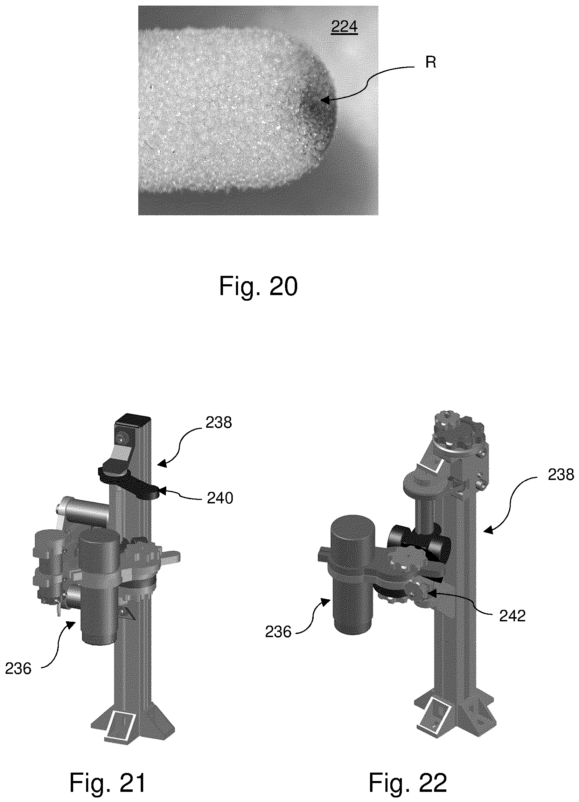

**Fig. 20** shows residues R of rGO on a head paddle, such as the head paddle 224 of the wiping device 220, after wiping.

In the present embodiment, the system 300 comprises a camera 236.

In the present embodiment, the camera is mounted on a support 238, as shown in **Figs. 21-****22.**

The support 238 comprises a camera adjustment means 240; 242 for adjusting a position of the camera 236.

In a non-limiting example, the camera adjustment means 240 may include a lever, as shown in **Fig. 21****.**

Alternatively, the camera adjustment means 242 may comprise an adjustment screw, as shown in **Fig. 22****.**

Not shown is that other configurations for the camera adjustment means are also possible according to the invention.

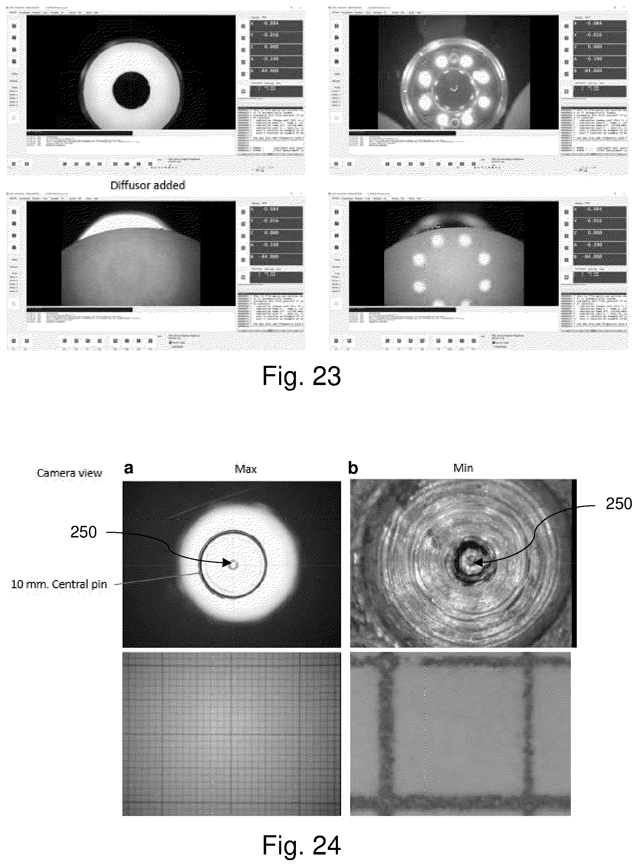

**Fig. 23** shows different views of the camera 236, taken from below, with or without a diffusor.

The camera includes a plurality of LEDs to illuminate an object.

Due to occurring reflections, each LED defines a light spot, as visible in the figure.

By adding a diffusor in front of the LEDs, a more homogeneous light can be provided.

**Fig. 24** shows images captured by the camera 236 **(****Fig. 24(a)****:** maximum distance; **Fig. 24(b)****:** minimum distance, i.e., maximum zoom).

Here, the images are focused on the central pin 250 of the base portion 214.

The central pin 250 serves as an alignment for the wafer holder 216.

In particular, the wafer holder 216 is configured to engage with and rotate about the central pin 250, which therefore acts as "zero" coordinate for the wafer holder 216.

Images captured by the camera 236 can be displayed on a display means (not shown).

The display means may be embedded in the wiping system 300.

Alternatively, the display means may be comprised in an external device, e.g., a laptop, tablet computer, or the like (not shown), operatively connected to the camera 236.

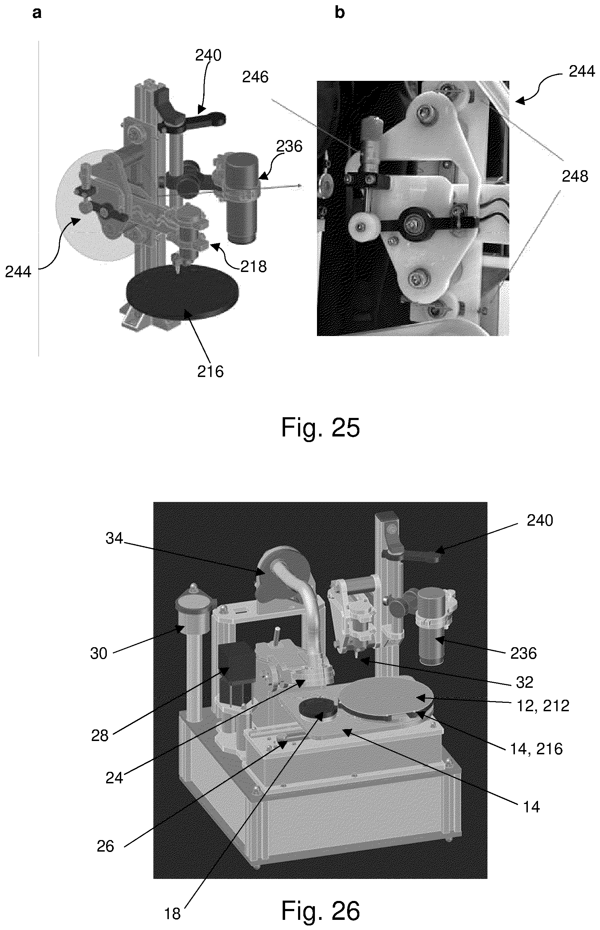

In the present embodiment, the system 300 comprises a wiping device adjustment means 244 for adjusting a position of the wiping device 220 **(****Fig. 25****).**

In the present embodiment, the wiping device adjustment means 244 is arranged in the support 238 (see emphasized area in **Fig. 25(a)****).**

Not shown is that a different arrangement for the wiping device adjustment means 244 is also possible according to the invention.

In the present embodiment, the wiping device adjustment means 244 includes a height adjustment means 246, for adjusting a height of the wiping device 220 with respect to the wafer holder 216, and a fine-adjustment means 248 for tuning orientation of the wiping device 220 **(****Fig. 25(b)****).**

Not shown is that a different setup for the wiping device adjustment means 244 is also possible according to the invention.

Operation of the wiping system 300 components is mostly or entirely software-controlled.

Optionally, the wiping system 300 can be integrated into the transfer system 100 described above, thus forming a single, integrated system.

An example of integrated system is shown in **Fig. 26****.**

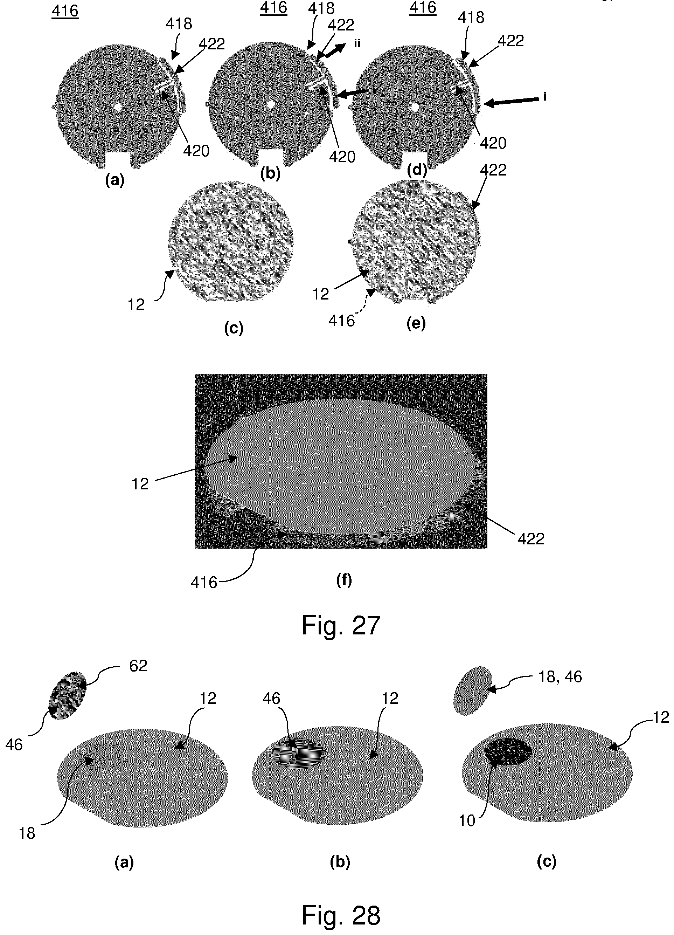

**Fig. 27** shows an alternative configuration for the wafer holder 416 along with its functioning.

The wafer holder 416 according to the present embodiment is shown in detail in **Fig. 27(a)****.**

The wafer holder 416 is similar to the wafer holder 16, 216 described above, but is further implemented with a clamping means 418.

In the shown solution, the clamping means 418 is T-shaped **(****Fig. 27****).**

In detail, the T-shaped clamping means 418 comprises a pin 420, acting as a rotation point, and a handle portion 422.

By exerting a pushing force on the lower part of the handle portion 422 in the direction of arrow **i** in **Fig. 27(b)****,** the clamping means 418 will move outwards in the direction of arrow **ii** in the same **Fig. 27(b)****.**

Accordingly, space is made for the placement of the wafer 12 (schematically illustrated in **Fig. 27(c)****)** on the wafer holder 416.

Once the wafer 12 is placed on the wafer holder 416, the pushing force is released, so that the clamping means 418 moves inwards.

Accordingly, the wafer 14 is clamped and maintained in place on the wafer holder 416 through the clamping means 418, as schematically illustrated in **Fig. 27(e)****-(f).**

The transfer system 100 described above is suitable for use in a method of transferring a thin film to and on a wafer.

As a non-limiting example, the thin film is a graphene-containing film, e.g. a rGO flakes layer.

In the below-described example, the thin film is the rGO flakes layer 10 described above with respect to the transfer system 100.

In one example, the method comprises:
providing at least one rGO flakes layer 10 into the carrier 18;
providing a wafer 12 on the wafer holder 16;
operating the vacuum generating device to generate a vacuum for holding the wafer 12 in place on the wafer holder 16;
operating the movement transmission means 26 to position the wafer holder 16 with the wafer 12 under the water droplet application means 32;
operating the water pump 28 to apply a water droplet on the wafer 12 through the water droplet application means 32;
operating the movement transmission means 26 for positioning the carrier 18 with the at least one rGO flakes layer 10 under the pickup head 24 of the pickup assembly 20;
operating the motor of the pickup assembly 20 to move the pickup arm 22 from the lifted position toward the lowered position;
operating the air pump to generate an airflow in a first airflow direction for holding the rGO flakes layer 10 in place within the pickup head 24 for transfer;
operating the motor of the pickup assembly 20 to control movement of the pickup arm 22 from the lowered position toward the lifted position;
operating the movement transmission means 26 to position the wafer holder 16 with the wafer 12 under the pickup head 24;
operating the additional vacuum generating device to generate a vacuum for removing water from the wafer 12;
operating the motor of the pickup assembly 20 to move the pickup arm 22 from the lifted position toward the lowered position to transfer the rGO flakes layer 10 from the pickup head 24 on the wafer 12;
operating the airflow switch 34 to direct an airflow from the air pump in a second airflow direction for drying the wafer 12 with the rGO flakes layer 10 for a predetermined period of time, preferably for 5 minutes;
turning off the vacuum generating device and the air pump;
moving the pickup arm 22 from the lowered position toward the lifted position to allow for removal of the wafer 12 from the wafer holder 16, and
removing the wafer 12 from the wafer holder 16.

**Fig. 28** shows a solution for facilitating removal of the carrier 18 from the wafer 12 once a thin film, here rGO flakes layer 10, is dried and adheres to a surface of the wafer 12.

Fig. **28(a)** shows the carrier 18 placed on the wafer 12 with the rGO flakes layer 10 placed on its bottom side (i.e., the side facing the surface of the wafer 12).

The dried rGO flakes layer 10 adheres to the surface of the wafer 12.

A paper disk 46 is provided, having an adhesive 62 **(****Fig. 28(a)****).**

For instance, said adhesive can be a double-sided adhesive tape, as schematically illustrated in **Fig. 28(a)****.**

The paper disc 46 is placed over the carrier 18 as schematically illustrated in **Fig. 28(b)****,** so that the adhesive 62 adheres to the upper surface of the carrier 18.

Eventually, the paper disk 46 and the carrier 18, connected to one another through the adhesive 62, are removed from the wafer 12, while the rGO flakes layer 10 remains on the wafer 12, as shown in **Fig. 28(c)****.**

Alternatively, a stripe 48, e.g. a paper or metal stripe 48, having an adhesive 64 can be used instead of the paper disc 46.

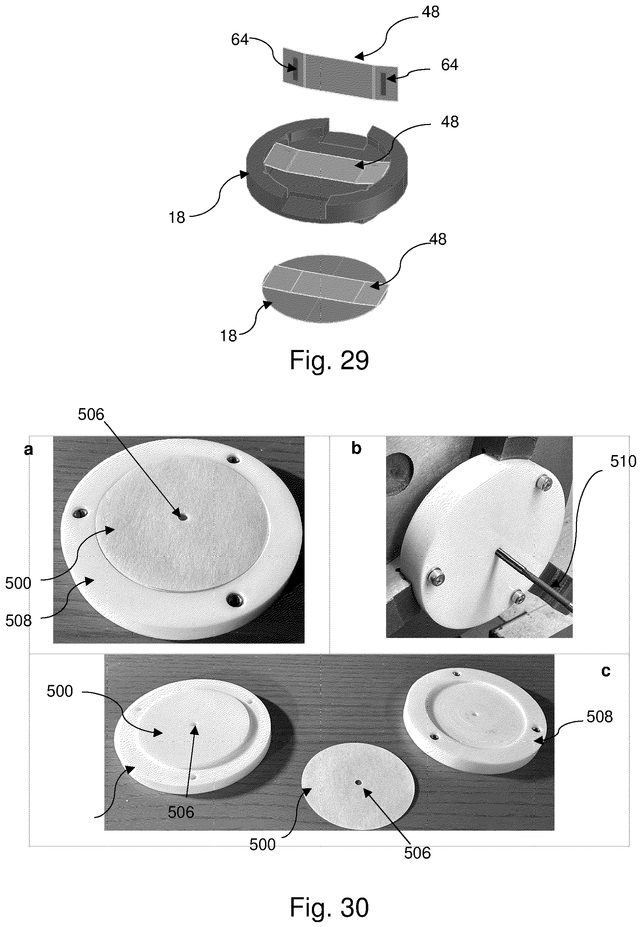

This alternative solution is illustrated in **Fig. 29****.**

Similar as above, a double-sided adhesive tape can be used for the adhesive 64.

Once the paper disk 46 or the paper or metal stripe 48 is placed on the carrier 18, a peel-off force is exerted on the carrier 18, which allows for easy removal.

A computer-readable non-volatile storage medium can be provided, said storage medium comprising computer-readable instructions that, when executed by a processing means, causes said processing means to implement and/or process and/or perform the method steps defined above.

The wiping system 300 described above is suitable for use in a method of wiping a rim area of a thin film deposited on a wafer.

As a non-limiting example, the thin film is a graphene-containing film, e.g. a rGO flakes layer.

In particular, in the below-described example, the rGO flakes layer is the rGO flakes layer 210 described above with respect to the wiping system 300.

In one example, the method comprises:
placing the wafer holder 216 on the base portion 214;
placing the wafer 212 with the at least one rGO flakes layer 210 on the wafer holder 216;
connecting the wiping device 220 to the wiping device holder 226;
optionally adjusting height and/or orientation of the wiping device 220 with respect to the wafer holder 216;
moving the wiping assembly arm 230 from a lifted position toward a lowered position;
controlling the motor 228 of the wiping assembly 218 to operate the wiping device 220 to wipe a rim area of the rGO flakes layer 210;
when wiping is completed, controlling the motor 228 to stop operation of the wiping device 220;
moving the wiping assembly arm 230 from the lowered position toward the lifted position, and
removing the wafer 212 from the wafer holder 216.

### Placement accuracy test

Experiments have been carried out by the inventors to test placement accuracy in the transfer system 100 of the invention.

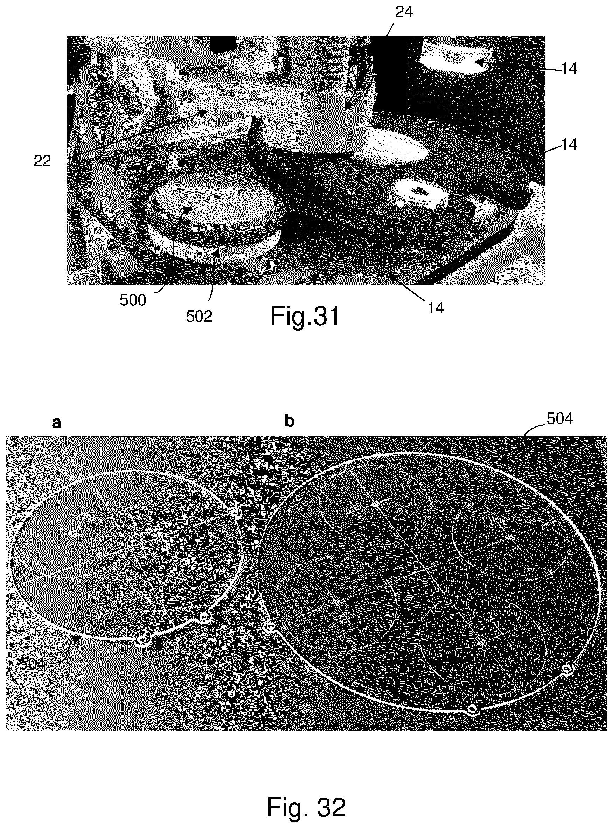

The test was carried out using paper sheets 500 (simulating thin films, e.g. the rGO flakes described above, see **Fig. 30(a) and (c)****),** placed in a transfer carrier 502 (best shown in **Fig. 31****),** and test wafers 504 of different dimensions **(****Figs. 30-31****).**

The transfer carrier 502 was specifically adapted to the outer diameter of the paper sheets 500.

An adhesive tape (not shown) was placed under the paper sheets 500.

The paper sheets 500 have a center hole 506, formed by using a device comprising a support 508 and a reamer 510 (best shown in **Fig. 30(b)****).**

The center hole 506 allowed for placement checking **(****Figs. 30(a)** and **(c)****).**

An experimental setup for the placement accuracy test is illustrated in **Fig. 31****.**

The transfer carrier 502 holding one paper sheet 500 was arranged on the base plate 14.

A test wafer 504 was placed on the wafer holder 16.

The vacuum device was operated to generate a vacuum to maintain the test wafer 504 in place on the wafer holder 16 during testing.

The movement transmission means 26 was operated to bring the test carrier 502 under the pickup head 24

The pickup arm 22 was moved to the lowered position and the paper sheet 500 was picked up by the pickup head 24.

The movement transmission means 26 were operated to move the test wafer 504 under the pickup head 24, and the paper sheet 500 was deposited on the test wafer.

Then, placement accuracy of the paper sheet 500 on the test wafer 504 was measured.

This process was repeated for each position on the test wafer 504.

Two different test wafers 504 were used in the experiment, namely a 4-inch test wafer **(****Fig. 32(a)****)** and a 6-inch test wafer **(****Fig. 32(b)****).**

The test wafers 504 are made of polymethyl methacrylate (PMMA).

The test wafers 504 have a thickness of 2 mm.

Placement accuracy was measured by analyzing images captured by the camera 36 **(****Fig. 31****).**

For this purpose, software means were implemented in the controller to measure coordinates.

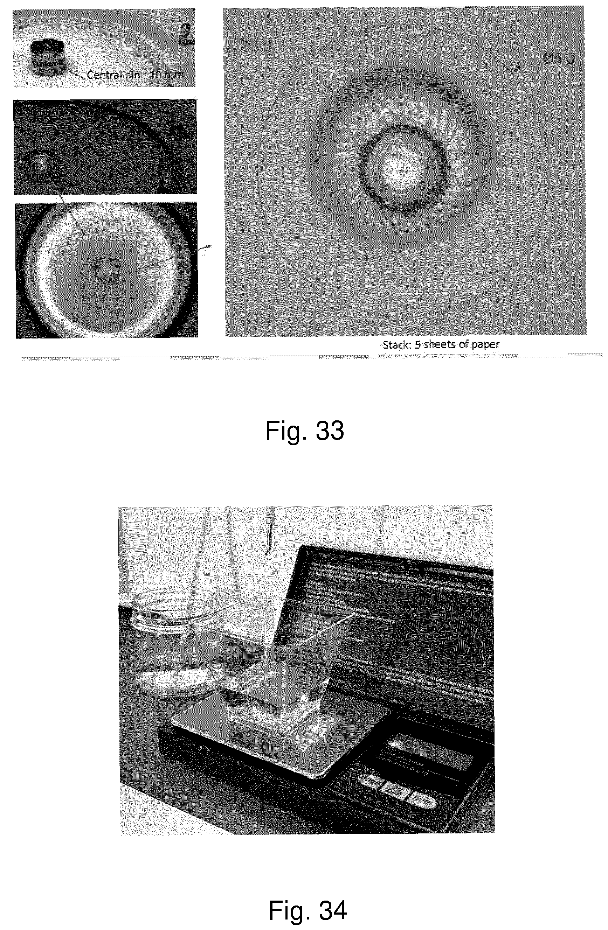

Exemplary images captured by the camera 36 are shown in **Fig. 33****.**

The test revealed a position accuracy of +/- 0.5 mm.

### Water dosing accuracy test

Experiments have been carried out by the inventors to test water dosing accuracy in the transfer system 100 of the invention.

The test was carried out using the experimental setup shown in **Fig. 34****,** implemented in the transfer system 100.

Weight measurements were carried out using a pocket scale 0-100 gr, as illustrated in **Fig. 34****.**

The test set-up included 5 runs, where 9 water droplets were used in each run.

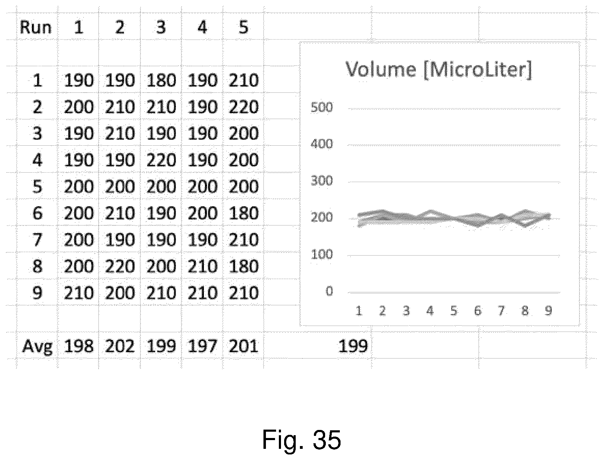

The results of the water dosing accuracy test are shown in detail in **Fig. 35****.**

While placing the thin film such as a rGO flakes layer on the wafer, a minimum volume of water is required in order to fill the gap between the rGO flakes layer and the substrate.

In particular, the required minimum volume of water is 150 microliter.

The excess of water is removed, e.g. via a vacuum generating device as described in the foregoing.

The obtained experimental data demonstrate a robust process.

In connection with the above disclosure, the following aspects are explicitly disclosed:
**Aspect 1:** A transfer system (100) for transferring a thin film (10), especially a graphene-containing film (10), e.g. a reduced graphene oxide (rGO) flakes layer (10), to and on a wafer (12), the system (100) comprising:
   a base plate (14);
   a wafer holder (16) configured to hold a wafer (12), the wafer holder (16) being arranged on the base plate (14);
   a carrier (18) for at least one thin film (10) to be transferred on the wafer (12);
   a pickup assembly (20) comprising:
      a pickup arm (22);
      a pickup head (24), configured to pick up a thin film (10) from the carrier (18) and subsequently deposit the thin film (10) on the wafer (12), and
      a motor, configured to determine movement of the pickup arm (22) between a lifted position and a lowered position,
   a movement transmission means (26), configured to move the base plate (14) to a desired position;
   a vacuum generating device, and
   a controller,
   wherein the controller is configured to:
      operate the vacuum generating device to generate a vacuum for holding the wafer (12) in place on the wafer holder (16).
**Aspect 2:** The system (100) of Aspect 1, wherein the system (100) further comprises a water pump (28) in fluid connection with a water reservoir (30).
**Aspect 3:** The system (100) of Aspect 2, wherein the system (100) further comprises a water droplet application means (32) in fluid connection with the water pump (28),
   wherein the controller is further configured to:
   operate the movement transmission means (26) to position the wafer holder (16) with the wafer (12) under the water droplet application means (32), and
   operate the water pump to apply a water droplet on the wafer (12) through the water droplet application means (32).
**Aspect 4:** The system (100) of any of the preceding Aspects, wherein the system (100) further comprises an air pump provided with an airflow switch (34) for directing an airflow generated by the air pump in a desired airflow direction.
**Aspect 5:** The system (100) of Aspect 4, wherein the controller is further configured to:
   operate the movement transmission means (26) for positioning the carrier (18) with the at least one thin film (10) under the pickup head (24) of the pickup assembly (20);
   operate the motor of the pickup assembly (20) to move the pickup arm (22) from the lifted position toward the lowered position;
   operate the air pump to generate an airflow in a first airflow direction for holding the thin film (10) in place in the pickup head (24) for transfer;
   operate the motor of the pickup assembly (20) to move the pickup arm (22) from the lowered position toward the lifted position;
   operate the movement transmission means (26) to position the wafer holder (16) with the wafer (12) under the pickup head (24), and
   operate the motor of the pickup assembly (20) to control movement of the pickup arm (22) from the lifted position toward the lowered position to transfer the thin film (10) from the pickup head (24) on the wafer (12).
**Aspect 6:** The system (100) of Aspect 5, wherein the system (100) further comprises an additional vacuum generating device and wherein, after operating the movement transmission means (26) to position the wafer holder (16) with the wafer (12) under the pickup head (24), the controller is further configured to operate the additional vacuum generating device to generate a vacuum for removing water from the wafer (12).
**Aspect 7:** The system (100) of Aspect 5 or 6, wherein the controller is further configured to operate the airflow switch (34) to direct an airflow from the air pump in a second airflow direction for drying the wafer (12) with the thin film (10).
**Aspect 8:** The system (100) of any of Aspects 5 to 7, wherein the controller is further configured to:
   turn off the vacuum generating device and the air pump, and
   operate the motor of the pickup assembly (20) to control movement of the pickup arm (22) from the lowered position toward the lifted position to allow for removal of the wafer (12) from the wafer holder (16).
**Aspect 9:** The system (100) of any of the preceding Aspects, wherein the system (100) further comprises a sensor means (36) for inspection and measurement, preferably wherein said sensor means (36) for inspection and measurement includes a camera (36).
**Aspect 10:** The system (100) of any of the preceding Aspects, wherein:
   the base plate (14) comprises a plurality of base plate alignment pins (38) to allow for correct positioning of the wafer holder (16) on the base plate (14),
   preferably wherein said plurality of base plate alignment pins (38) include three alignment pins (38), wherein two alignment pins (38) are arranged at a front portion of the base plate (14), and one alignment pin (38) is arranged on one side of the base plate (14), and/or
   the wafer holder (16) comprises a plurality of wafer holder alignment pins (40) to allow for correct positioning of the wafer (12) on the wafer holder (16),
   preferably wherein said plurality of wafer holder alignment pins (40) include three alignment pins (40), wherein two alignment pins (40) are arranged at a front portion of the wafer holder (16), and one alignment pin (40) is arranged on one side of the wafer holder (16),
   preferably wherein:
   the wafer holder (16) is configured to hold a 4-inch wafer, or
   the wafer holder (16) is configured to hold a 6-inch wafer.
**Aspect 11:** The system (100) of any of the preceding Aspects, wherein the system (100) further comprises a protective casing (42) enclosing system components,
   preferably wherein the sensor means (36) for inspection and measurement, e.g., a camera (36), is integrated into the protective casing (42), preferably arranged on a top portion of the protective casing (42),
   preferably wherein the system (100) further comprises a cable box (44) for re-routing cables of the system (100).
**Aspect 12:** A wiping system (300) for wiping a rim area of a thin film (210), especially a graphene-containing film (210), e.g. a reduced graphene oxide (rGO) flakes layer (210) deposited on a wafer (212), the system (300) comprising:
   a base portion (214);
   a wafer holder (216), arranged on the base portion (214), the wafer holder (216) being configured to hold a wafer (212) with at least one thin film (210) deposited on one surface;
   a wiping assembly (218), comprising:
      a wiping device (220), the wiping device comprising a handle (222) and a head paddle (224) made of a flexible material;
      a wiping device holder (226), configured for connection to the handle (222) to maintain the wiping device (220) in place for use, and
      a motor (228) for controlling operation of the wiping device (220), and
   a wiping assembly arm (230), connected to the wiping assembly (218), the wiping assembly arm (230) being configured to switch between a lifted position and a lowered position.
**Aspect 13:** The system (300) of Aspect 12, wherein the system (300) further comprises a vacuum generating device (232) configured to generate vacuum to maintain the wafer (212) in place on the wafer holder (216).
**Aspect 14:** The system (300) of Aspect 12 or 13, wherein the wiping assembly (218) further comprises a tubular component (234) made of a flexible material, the tubular component (234) being connected to the handle (222), wherein the tubular component (234) is configured for connection to the wiping device holder (226).
**Aspect 15:** The system (300) of any Aspects 12 to 14, wherein the system (300) further comprises a camera (236), preferably wherein the camera (236) is mounted on a support (238), more preferably wherein the support (238) comprises a camera adjustment means (240; 242) for adjusting a position of the camera (236).
**Aspect 16:** The system (300) of any Aspects 12 to 15, wherein the system (300) further comprises a wiping device adjustment means (244) for adjusting a position of the wiping device (220), preferably wherein said wiping device adjustment means (244) comprises:
   height adjustment means (246), for adjusting a height of the wiping device (220) with respect to the wafer holder (216), and/or
   fine-adjustment means (248) for tuning orientation of the wiping device (220).
**Aspect 17:** The system (300) of any Aspects 12 to 16, wherein the base portion (214) comprises at least one base portion alignment pin (250) configured for engagement with a corresponding at least one alignment hole (252) formed on a surface of the wafer holder (216), preferably wherein the base portion (214) comprises a plurality of alignment pins (250) configured for engagement with corresponding alignment holes (252) of the wafer holder (216).
**Aspect 18:** The system (300) of any Aspects 12 to 17, wherein the wiping system (300) is configured to be integrated into the transfer system (100) according to any of Aspects 1 to 11.
**Aspect 19:** A method of transferring a thin film (10), especially a graphene-containing film (10), e.g. a reduced graphene oxide (rGO) flakes layer (10), to and on a wafer (12) by using the system (100) according to any of Aspects 1 to 11, the method comprising:
   providing at least one thin film (10) into the carrier (18);
   providing a wafer (12) on the wafer holder (16);
   operating the vacuum generating device to generate a vacuum for holding the wafer (12) in place on the wafer holder (16);
   operating the movement transmission means (26) to position the wafer holder (16) with the wafer (12) under the water droplet application means (32);
   operating the water pump (28) to apply a water droplet on the wafer (12) through the water droplet application means (32);
   operating the movement transmission means (26) for positioning the carrier (18) with the at least one thin film (10) under the pickup head (24) of the pickup assembly (20);
   operating the motor of the pickup assembly (20) to move the pickup arm (22) from the lifted position toward the lowered position;
   operating the air pump to generate an airflow in a first airflow direction for holding the thin film (10) in place within the pickup head (24) for transfer;
   operating the motor of the pickup assembly (20) to control movement of the pickup arm (22) from the lowered position toward the lifted position;
   operating the movement transmission means (26) to position the wafer holder (16) with the wafer (12) under the pickup head (24);
   operating the additional vacuum generating device to generate a vacuum for removing water from the wafer (12);
   operating the motor of the pickup assembly (20) to move the pickup arm (22) from the lifted position toward the lowered position to transfer the thin film (10) from the pickup head (24) on the wafer (12);
   operating the airflow switch (34) to direct an airflow from the air pump in a second airflow direction for drying the wafer (12) with the thin film (10) for a predetermined period of time, preferably for 5 minutes;
   turning off the vacuum generating device and the air pump;
   moving the pickup arm (22) from the lowered position toward the lifted position to allow for removal of the wafer (12) from the wafer holder (16), and
   removing the wafer (12) from the wafer holder (16).
**Aspect 20:** The method of Aspect 19, wherein the step of providing at least one thin film (10) into the carrier (18) comprises providing a plurality of stacked thin films (10), preferably rGO flakes layers (10) into the carrier (18) with an adhesive tape (46) or an adhesive stripe (48) interposed therebetween.
**Aspect 21:** A method of wiping a rim area of a thin film (10), especially a graphene-containing film (10), e.g. a reduced graphene oxide (rGO flakes layer (210), deposited on a wafer (212) by using the wiping system (300) of any of Aspects 12 to 18, the thin film (210) being transferred on the wafer (212) by implementing the method of Aspect 19, the method comprising:
   placing the wafer holder (216) on the base portion (214);
   placing the wafer (212) with the at least one thin film (210), preferably a rGO flakes layer (210) on the wafer holder (216);
   connecting the wiping device (220) to the wiping device holder (226);
   optionally adjusting height and/or orientation of the wiping device (220) with respect to the wafer holder (216);
   moving the wiping assembly arm (230) from a lifted position toward a lowered position;
   controlling the motor (228) of the wiping assembly (218) to operate the wiping device (220) to wipe a rim area of the thin film (210);
   when wiping is completed, controlling the motor (228) to stop operation of the wiping device (220);
   moving the wiping assembly arm (230) from the lowered position toward the lifted position, and
   removing the wafer (212) from the wafer holder (216).

### References

- 100: Transfer system

- 300: Wiping system

- 10, 210: Thin film, reduced graphene oxide (rGO) flakes layer
- 12, 212: Wafer

- 14: Base plate
- 16, 216, 416: Wafer holder
- 18: Carrier
- 20: Pickup assembly
- 22: Pickup arm
- 24: Pickup head
- 26: Movement transmission means
- 28: Water pump
- 30: Water reservoir
- 32: Water droplet application means
- 34: Airflow switch
- 36: Sensor means for inspection and measurement, camera
- 38: Base plate alignment pin(s)
- 40: Wafer holder alignment pin(s)
- 42: Protective casing
- 44: Cable box
- 46: Paper disc
- 48: Stripe
- 50: X-home sensor
- 52: Rotation-home sensor
- 54: Air switch-home sensor
- 56: Z-home sensor
- 58: Electronic components
- 60: Control box
- 62: Adhesive (of the paper disc)
- 64: Adhesive (of the stripe)
- 66: Etch resist

- 214: Base portion
- 216: Wafer holder
- 218: Wiping assembly
- 220: Wiping device
- 222: Handle
- 224: Head paddle
- 226: Wiping device holder
- 228: Motor
- 230: Wiping assembly arm
- 232: Vacuum generating device
- 234: Tubular component
- 236: Camera
- 238: Support
- 240;242: Camera adjustment means
- 244: Wiping device adjustment means
- 246: Height adjustment means
- 248: Fine-adjustment means
- 250: Base portion alignment pin(s)
- 252: Alignment hole

- 418: Clamping means
- 420: Pin
- 422: Handle portion

- 500: Paper sheet(s)
- 502: Transfer carrier
- 504: Test wafer
- 506: Center hole
- 508: Support
- 510: Reamer

- A: Area
- R: Residues

- i: Arrow
- ii: Arrow
- iii: Arrow

## Claims

1. Transfer system (100) for transferring a thin film (10), especially a graphene-containing film (10), e.g. a reduced graphene oxide (rGO) flakes layer (10), to and on a wafer (12), the system (100) comprising:
a base plate (14);
a wafer holder (16) configured to hold a wafer (12), the wafer holder (16) being arranged on the base plate (14);
a carrier (18) for at least one thin film (10) to be transferred on the wafer (12);
a pickup assembly (20) comprising:
a pickup arm (22);
a pickup head (24), configured to pick up a thin film (10) from the carrier (18) and subsequently deposit the thin film (10) on the wafer (12), and
a motor, configured to determine movement of the pickup arm (22) between a lifted position and a lowered position,
a movement transmission means (26), configured to move the base plate (14) to a desired position;
a vacuum generating device, and
a controller,
wherein the controller is configured to:
operate the vacuum generating device to generate a vacuum for holding the wafer (12) in place on the wafer holder (16).

2. The system (100) of claim 1,
**characterized in that**
the system (100) further comprises a water pump (28) in fluid connection with a water reservoir (30).

3. The system (100) of claim 2,
**characterized in that**
the system (100) further comprises a water droplet application means (32) in fluid connection with the water pump (28),
wherein the controller is further configured to:
operate the movement transmission means (26) to position the wafer holder (16) with the wafer (12) under the water droplet application means (32), and
operate the water pump to apply a water droplet on the wafer (12) through the water droplet application means (32).

4. The system (100) of any of the preceding claims,
**characterized in that**
the system (100) further comprises an air pump provided with an airflow switch (34) for directing an airflow generated by the air pump in a desired airflow direction.

5. The system (100) of claim 4,
**characterized in that**
the controller is further configured to:
operate the movement transmission means (26) for positioning the carrier (18) with the at least one thin film (10) under the pickup head (24) of the pickup assembly (20);
operate the motor of the pickup assembly (20) to move the pickup arm (22) from the lifted position toward the lowered position;
operate the air pump to generate an airflow in a first airflow direction for holding the thin film (10) in place in the pickup head (24) for transfer;
operate the motor of the pickup assembly (20) to move the pickup arm (22) from the lowered position toward the lifted position;
operate the movement transmission means (26) to position the wafer holder (16) with the wafer (12) under the pickup head (24), and
operate the motor of the pickup assembly (20) to control movement of the pickup arm (22) from the lifted position toward the lowered position to transfer the thin film (10) from the pickup head (24) on the wafer (12).

6. The system (100) of claim 5,
**characterized in that**
the system (100) further comprises an additional vacuum generating device,
wherein, after operating the movement transmission means (26) to position the wafer holder (16) with the wafer (12) under the pickup head (24), the controller is further configured to:
operate the additional vacuum generating device to generate a vacuum for removing water from the wafer (12).

7. The system (100) of claim 5 or 6,
**characterized in that**
the controller is further configured to:
operate the airflow switch (34) to direct an airflow from the air pump in a second airflow direction for drying the wafer (12) with the thin film (10).

8. The system (100) of any of claims 5 to 7,
**characterized in that**
the controller is further configured to:
turn off the vacuum generating device and the air pump, and
operate the motor of the pickup assembly (20) to control movement of the pickup arm (22) from the lowered position toward the lifted position to allow for removal of the wafer (12) from the wafer holder (16).

9. The system (100) of any of the preceding claims,
**characterized in that**
the system (100) further comprises a sensor means (36) for inspection and measurement,
preferably wherein said sensor means (36) for inspection and measurement includes a camera (36).

10. The system (100) of any of the preceding claims,
**characterized in that**
the base plate (14) comprises a plurality of base plate alignment pins (38) to allow for correct positioning of the wafer holder (16) on the base plate (14),
preferably wherein said plurality of base plate alignment pins (38) include three alignment pins (38), wherein two alignment pins (38) are arranged at a front portion of the base plate (14), and one alignment pin (38) is arranged on one side of the base plate (14), and/or
the wafer holder (16) comprises a plurality of wafer holder alignment pins (40) to allow for correct positioning of the wafer (12) on the wafer holder (16),
preferably wherein said plurality of wafer holder alignment pins (40) include three alignment pins (40), wherein two alignment pins (40) are arranged at a front portion of the wafer holder (16), and one alignment pin (40) is arranged on one side of the wafer holder (16),
preferably wherein:
the wafer holder (16) is configured to hold a 4-inch wafer, or
the wafer holder (16) is configured to hold a 6-inch wafer.

11. Wiping system (300) for wiping a rim area of a thin film (210), especially a graphene-containing film (210), e.g. a reduced graphene oxide (rGO) flakes layer (210) deposited on a wafer (212), the system (300) comprising:
a base portion (214);
a wafer holder (216), arranged on the base portion (214), the wafer holder (216) being configured to hold a wafer (212) with at least one thin film (210) deposited on one surface;
a wiping assembly (218), comprising:
a wiping device (220), the wiping device comprising a handle (222) and a head paddle (224) made of a flexible material;
a wiping device holder (226), configured for connection to the handle (222) to maintain the wiping device (220) in place for use, and
a motor (228) for controlling operation of the wiping device (220), and
a wiping assembly arm (230), connected to the wiping assembly (218), the wiping assembly arm (230) being configured to switch between a lifted position and a lowered position.

12. The system (300) of claim 11,
**characterized in that**
the system (300) further comprises a vacuum generating device (232) configured to generate vacuum to maintain the wafer (212) in place on the wafer holder (216).

13. The system (300) of any claim 11 or 12,
**characterized in that**
the system (300) further comprises a camera (236),
preferably wherein the camera (236) is mounted on a support (238),
more preferably wherein the support (238) comprises a camera adjustment means (240; 242) for adjusting a position of the camera (236).

14. The system (300) of any of claims 11 to 13,
**characterized in that**
the system (300) further comprises a wiping device adjustment means (244) for adjusting a position of the wiping device (220),
preferably wherein said wiping device adjustment means (244) comprises:
height adjustment means (246), for adjusting a height of the wiping device (220) with respect to the wafer holder (216), and/or
fine-adjustment means (248) for tuning orientation of the wiping device (220).

15. The system (300) of any of claims 11 to 14,
**characterized in that**
the base portion (214) comprises at least one base portion alignment pin (250) configured for engagement with a corresponding at least one alignment hole (252) formed on a surface of the wafer holder (216),
preferably wherein the base portion (214) comprises a plurality of alignment pins (250) configured for engagement with corresponding alignment holes (252) of the wafer holder (216).
